# EUROPÄISCHE PATENTSCHRIFT

(11) **EP 0 769 850 B1**
(45) Veröffentlichungstag und Bekanntmachung des Hinweises auf die Patenterteilung: **29.01.2003**
(21) Anmeldenummer: 96202796.7
(22) Anmeldetag: 08.10.1996
(51) Int. Cl.: H03J 5/24

(54) **Hochfrequenz-Empfangsstufe**
High frequency tuner
Etage d'entrée haute fréquence

(30) Priorität: 17.10.1995 DE 19538543
(43) Veröffentlichungstag der Anmeldung: 23.04.1997
(73) Patentinhaber: Philips Corporate Intellectual Property GmbH, 20099 Hamburg (DE); Koninklijke Philips Electronics N.V., 5621 BA Eindhoven (NL)
(72) Erfinder: Ruitenburg, Leo, Philips Patentverwaltung GmbH, 22335 Hamburg (DE)
(74) Vertreter: Peters, Carl Heinrich, Dipl.-Ing.

(56) Entgegenhaltungen:
- EP-A- 0 348 697
- EP-A- 0 457 932
- EP-A- 0 668 656
- EP-A- 0 678 981
- ELECTRONIC COMPONENTS AND APPLICATIONS, Bd. 9, Nr. 4, 1989, EINDHOVEN NL, Seiten 240-252, XP000159337 N. BAARS: "ICs and Discrete Semiconductors for TV and VCR Tuners"
- SIEMENS COMPONENTS, Bd. 25, Nr. 2, 1.Mai 1990, Seiten 65-69, XP000128903 HOHMANN H ET AL: "ICS FOR TELEVISION AND VIDEO-RECORDER TUNERS: TUA 2017 AND SDA 3302"

## Beschreibung

Die Erfindung bezieht sich auf eine Hochfrequenz-Empfangsstufe gemäß dem Oberbegriff des unabhängigen Anspruchs 1. Die Erfindung bezieht sich ferner auf eine Hochfrequenz-Empfangsstufe gemäß dem Oberbegriff des unabhängigen Anspruchs 2.

Aus der EP 0 348 697 A2 ist ein Fernsehtuner bekannt, der einen gemeinsamen Antennenanschluß für zwei Frequenzbereiche aufweist, die die Frequenzen von VHF-Band I bis einschließlich Hyperband überstreichen. Dabei ist ein für die beiden Frequenzbereiche bemessenes Vorkreisfilter und eine Vorverstärkerschaltung sowie zwei eigenständige Bandfilter vorgesehen. Das Vorkreisfilter besteht aus einer Schwingkreisschaltung mit umschaltbaren Spulen, von der das vorselektierte Signal über einen gemeinsamen breitbandigen Vorverstärker an eine zweistufige Umschalteinrichtung geliefert wird, die gleichzeitig mit dem Vorkreisfilter umgeschaltet wird. An die Umschalteinrichtung sind die getrennten Bandfilter angeschlossen, welchen jeweils eine eigene Mischstufe nachgeschaltet ist. Damit sollen bei einfachem Schaltungsaufbau und niedrigem Platzbedarf gute Empfangseigenschaften und hohe Störsicherheit erzielt werden.

In der Druckschrift "Siemens Components", Vol. 25, Mai 1990, Seiten 65 bis 69, ist eine integrierte Schaltung für Femseh- und Videorekorder-Tuner mit der Typenbezeichnung TUA 2007X beschrieben, die einen VHF-Mischer, einen Hyperbandmischer und einen UHF-Mischer enthält. Zwischen einem hochohmigen Gegentakt-VHF-Mischereingang der integrierten Schaltung und dem VHF-Mischer, einem niederohmigen Gegentakt-Hyperband-Mischereingang der integrierten Schaltung und dem Hyperbandmischer sowie einem niederohmigen Gegentakt-UHF-Mischereingang der integrierten Schaltung und dem UHF-Mischer ist je ein Verstärker dargestellt.

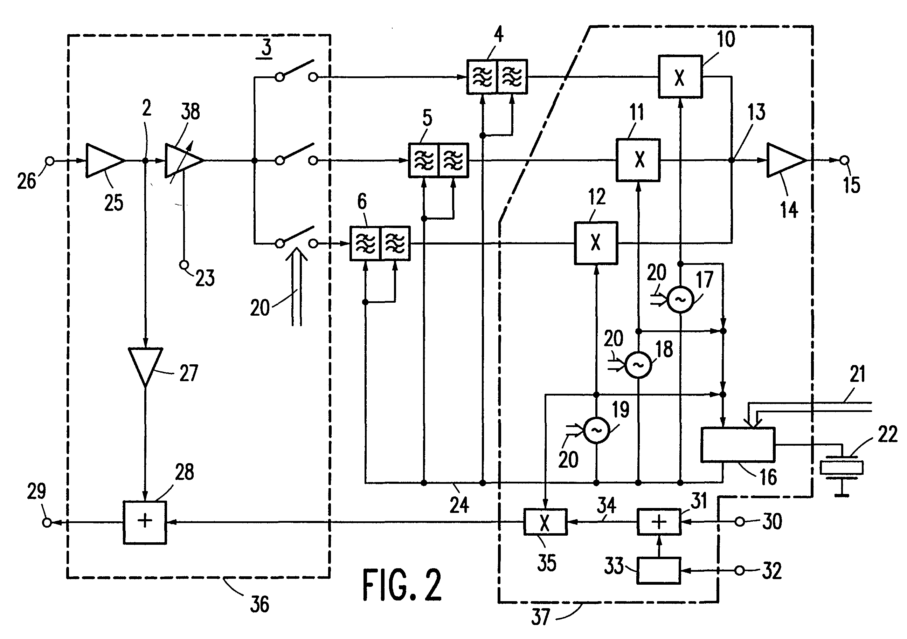

Aus der Druckschrift "Electronic Components & Applications", Vol. 9, Nr. 4, Seiten 240 bis 252, ist eine Prinzipschaltung eines Fernsehtuners mit einem Schaltkreis des Typs TDA5030A/AT entnehmbar. In der dortigen Fig. 2 ist einer Antenne, über die ein VHF- und ein Hyperbandsignal zugeführt werden, ein erstes Filter nachgeschaltet, auf das ein Verstärker folgt, der einen AGC-Eingang aufweist. Dem Verstärker ist ein zweites Filter nachgeschaltet, auf das ein Mischer folgt. Der dortigen Fig. 4 ist eine Anordnung entnehmbar, die je eine derartige Abfolge von Antenne, erstem Filter, Verstärker, zweitem Filter und Mischer für ein "High-Band", ein "Mid-Band" und ein "Low-Band" zeigt.

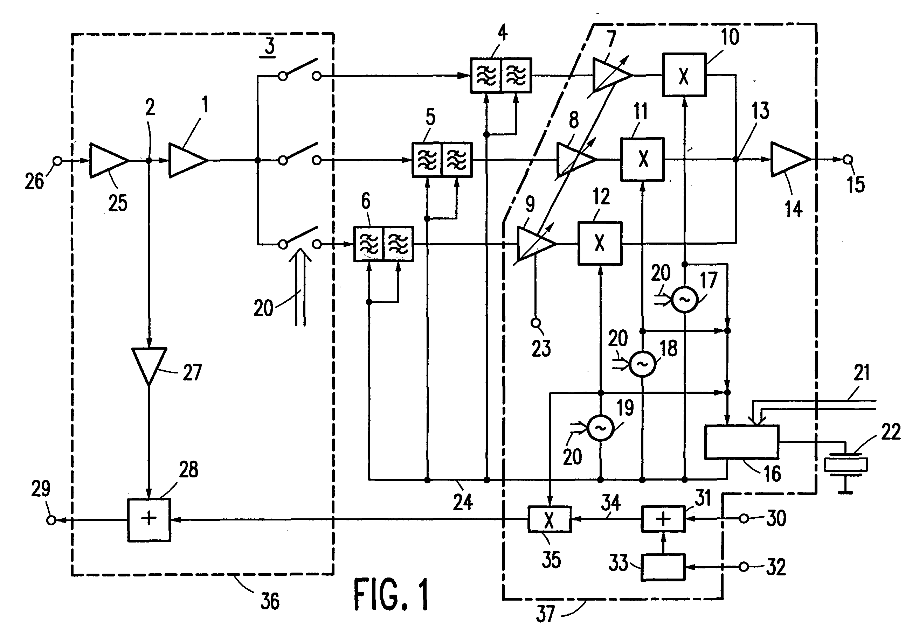

In Fig. 1 mit zugehöriger Beschreibung der europäischen Patentanmeldung EP 0 678 981 A, die am 25.10.95 veröffentlicht wurde, ist ebenfalls eine Hochfrequenz-Empfangsstufe mit einer Abfolge von Antenne, erstem Filter, Verstärker, zweitem Filter und Mischer dargestellt, wie sie der Fig. 4 der Druckschrift "Electronic Components & Applications", Vol. 9, Nr. 4, Seiten 240 bis 252 entspricht. Wie in der europäischen Patentanmeldung EP 0 678 981 A ausgeführt ist, kann mit einer derartigen Anordnung eine Vereinfachung des Aufbaus und eine Verringerung des dafür benötigten Bauvolumens noch nicht im wünschenswerten Maße erzielt werden.

In der europäischen Patentanmeldung EP 0 678 981 A ist eine Hochfrequenz-Empfangsstufe (Tuner) mit wenigstens zwei Signalverarbeitungszweigen zum frequenzselektiven Empfangen, Verstärken und/oder Frequenzmischen von Hochfrequenzsignalen beschrieben. Diese Hochfrequenz-Empfangsstufe enthält eine Umschaltstufe, über welche die von einem Eingang zuführbaren Hochfrequenzsignale wahlweise auf einen der Signalverarbeitungszweige geleitet werden können. In jedem Signalverarbeitungszweig ist weiterhin je eine an die Umschaltstufe angeschlossene Filterstufe enthalten, eine der Filterstufe nachgeschaltete, steuerbare Verstärkerstufe und eine an die Verstärkerstufe sich anschließende Mischstufe. Dabei sind die Mischstufen mit ihren Ausgän gen über eine Signalzusammenfürung an einen gemeinsamen Ausgangszweig angeschlossen.

Bei der beschriebenen Hochfrequenz-Empfangsstufe soll ein geringes Bauvolumen bei reduzierten Herstellungskosten ermöglicht werden.

Es hat sich gezeigt, daß einerseits eine weitere Verringerung des Rauschens, d.h. eine Verbesserung des Signal-Rausch-Verhältnisses, wünschenswert und daß andererseits die Rückflußdämpfung in den Signalverarbeitungszweigen verringert wird, wenn die Mischstufe sich unmittelbar an die (steuerbare) Verstärkerstufe im Signalverarbeitungszweig anschließt. Die zurückgestreuten Signale können über den Eingang auf eine mit diesem verbundene Antenne gelangen und so zu unberechenbaren Störungen führen.

Die Erfindung hat die Aufgabe, die Rückflußdämpfung der Hochfrequenz-Empfangsstufe mit geringem Aufwand zu erhöhen, ohne die Vorteile der in der europäischen Patentanmeldung EP 0 678 981 A beschriebenen Hochfrequenz-Empfangsstufe zu verlieren.

Diese Aufgabe wird erfindungsgemäß gelöst durch eine Hochfrequenz-Empfangsstufe (Tuner) mit den Merkmalen des unabhängigen Anspruchs 1.

Erfindungsgemäß wird die vorstehende Aufgabe auch gelöst durch eine Hochfrequenz-Empfangsstufe (Tuner) mit den Merkmalen des unabhängigen Anspruchs 2.

In der europäischen Patentanmeldung EP 0 678 981 A ist beschrieben worden, daß nach einem bis dahin gebräuchlichen Konstruktionsprinzip jeder Signalverarbeitungszweig nacheinander eine erste Filterstufe, eine steuerbare Verstärkerstufe, anschließende Filterstufen und eine Mischstufe zum Herabmischen der zugeführten Hochfrequenzsignale in ihrer Frequenz umfaßt. Dabei diente die steuerbare Verstärkerstufe zur Rauschverminderung des Hochfrequenzsignals vor der Selektion in den sich anschließenden Filterstufen. Beim Gegenstand der vorliegenden Erfindung wird diese Rauschverminderung, d.h. eine Verbesserung des Signal-Rausch-Verhältnisses, durch den breitbandigen Eingangsverstärker vorgenommen. Dies führt insbesondere bei einem Einsatz der erfindungsgemäßen Hochfrequenz-Empfangsstufe in einem Videorecorder zu einem sehr einfachen und kostengünstigen Aufbau, da ein breitbandiger Eingangsverstärker der genannten Art bereits in der Antenneneingangsstufe des Videorecorders zum Durchschleifen der Hochfrequenzsignale an einen nachgeschalteten Fernsehempfänger (Monitor) vorhanden ist. Die erwünschte Rauschverminderung wird somit ohne zusätzlichen Schaltungsaufwand erreicht.

Der breitbandige Eingangsverstärker dämpft außerdem Einstreuungen insbesondere eines leistungsstarken Oszillatorsignals für das Herabmischen der Hochfrequenzsignale in den Mischstufen. Eine solche Rückstreuung insbesondere des Oszillatorsignals von den Mischstufen bis in die Antenne kann begünstigt werden, wenn im Signalweg für das Hochfrequenzsignal im Signalverarbeitungszweig nicht unmittelbar vor der Mischstufe eine Filterstufe angeordnet ist. Die Erfindung ermöglicht, diese Rückstreuung ohne zusätzliche Maßnahmen auf ein unbedeutendes Maß zu dämpfen. Insbesondere kann dann eine Halbleiterintegration der steuerbaren Verstärkerstufe und der Mischstufe ohne Nachteile für die Signalverarbeitung vorgenommen werden.

Bei herkömmlichen Hochfrequenz-Empfangsstufen wurde außerdem durch die Anordnung der (steuerbaren) Verstärkerstufen am Anfang der Signalverarbeitungszweige die nötige Impedanzanpassung zwischen einem mit dem Eingang verbundenen Antennenanschluß und den Filterstufen in der Hochfrequenz-Empfangsstufe sichergestellt. Auch diese Impedanzanpassung kann vorteilhaft ohne zusätzlichen Schaltungsaufwand von dem erfindungsgemäß angeordneten breitbandigen Eingangsverstärker vorgenommen werden.

Darüberhinaus entfällt bei der erfindungsgemäßen Hochfrequenz-Empfangsstufe ebenfalls die gesonderte erste Filterstufe zwischen dem Eingang und der (steuerbaren) Verstärkerstufe, die letztere vor Intermodulation schützen sollte.

Bei der Erfindung ist entweder der breitbandige Eingangsverstärker mit einem festen Verstärkungsfaktor ausgebildet, und die in jedem der Signalverarbeitungszweige der Mischstufe vorgeschaltete Verstärkerstufe ist mit einem steuerbaren Verstärkungsfaktor ausgebildet, oder der breitbandige Eingangsverstärker ist in seinem Verstärkungsfaktor einstellbar, wodurch dann in den Signalverarbeitungszweigen gesonderte, den Mischstufen vorgeschaltete Verstärkerstufen entfallen oder bei Bedarf allenfalls mit konstantem Verstärkungsfaktor ausgebildet werden können. Die Lösung mit dem breitbandigen, steuerbaren Eingangsverstärker bietet einen besonders einfachen Aufbau, der sich insbesondere auch für standardisierte Ausbildungen der Hochfrequenz-Empfangsstufe eignet. Der breitbandige, steuerbare Eingangsverstärker kann vorteilhaft zum Aufbau einer Amplituden- bzw. Leistungsregelung herangezogen werden.

Weist der breitbandige Eingangsverstärker einen konstanten Verstärkungsfaktor auf, können die steuerbaren Verstärkerstufen in den Signalverarbeitungszweigen für die Amplituden- bzw. Leistungsregelung herangezogen werden. Dieser Aufbau begünstigt einen einfachen Aufbau einer Antennen-Eingangsstufe für einen Videorecorder zu Lasten einer in den Signalverarbeitungszweigen vorzunehmenden Amplituden- bzw. Leistungsregelung.

Vorzugsweise sind bei einer erfindungsgemäßen Hochfrequenz-Empfangsstufe die Mischstufen aller Signalverarbeitungszweige mit einem gemeinsamen Schwingungsgenerator verbunden, wobei der Schwingungsgenerator eine gemeinsame phasenverriegelte Schleife und zu jedem der Signalverarbeitungszweige eine gesonderte Oszillatorstufe umfaßt. Vorzugsweise ist je ein Signalverarbeitungszweig für einen vorgegebenen Frequenzbereich (band) ausgestattet. Für jedes der Bänder ist dann eine Oszillatorstufe vorgesehen, für alle Bänder gemeinsam jedoch eine phasenverriegelte Schleife. Dadurch kann die Gleichlauf-Anpassung zwischen den Filterstufen und den Oszillatoren innerhalb jedes der Signalverarbeitungszweige vereinfacht werden.

Weitere vorteilhafte Ausgestaltungen der Erfindung sind in den Unteransprüchen aufgeführt.

Die Figuren der Zeichnung, in denen übereinstimmende Elemente mit denselben Bezugszeichen versehen sind, zeigen zwei Ausführungsbeispiele der erfindungsgemäßen Hochfrequenz-Empfangsstufe.

Im Ausführungsbeispiel der Hochfrequenz-Empfangsstufe nach Fig. 1 umfaßt diese einen breitbandigen Eingangsverstärker 1, der eingangsseitig mit einem Eingang 2 für die Hochfrequenzsignale und ausgangsseitig mit einer Umschaltstufe 3 verbunden ist, sowie drei sich an die Umschaltstufe 3 anschließende Signalverarbeitungszweige mit einer abschließenden Signalzusammenführung. Jeder der Signalverarbeitungszweige umfaßt in Fig. 1 Filterstufen 4, 5 bzw. 6, die sich an die Umschaltstufe 3 anschließen, je eine steuerbare Verstärkerstufe 7, 8 bzw. 9 im Anschluß an die Filterstufen 4, 5 bzw. 6 sowie je eine Mischstufe 10, 11 bzw. 12 im Anschluß an die zugehörige steuerbare Verstärkerstufe 7, 8 bzw. 9. Vom Eingang 2 für die Hochfrequenzsignale werden diese über den breitbandigen Eingangsverstärker und die Umschaltstufe 3 wahlweise einem der Signalverarbeitungszweige zugeführt. Im Signalverarbeitungszweig wird das gewünschte, dem Signalverarbeitungszweig zugeordnete Frequenzband in der Filterstufe 4, 5 bzw. 6 selektiert. Über die steuerbaren Verstärkerstufen 7, 8 bzw. 9 werden den Mischstufen 10, 11 bzw. 12 dann die Hochfrequenzsignale ausschließlich des ausgefilterten Frequenzbandes zugeführt und in den Mischstufen 10, 11 bzw. 12 in ihrer Frequenz herabgemischt. Die Signalzusammenführung, in der Anordnung nach Fig. 1 durch einen Leitungsknoten 13 und einen Ausgangsverstärker 14 gebildet, ermöglicht eine Zufuhr der herabgemischten Hochfrequenzsignale zu einem gemeinsamen Ausgang 15. Begrifflich kann dabei wahlweise die Signalzusammenführung auch nur den Leitungsknoten umfassen; der Ausgangsverstärker 14 gehört dann zusammen mit dem Ausgang 15 bereits zu einem für alle Signalverarbeitungszweige gemeinsamen Ausgangszweig.

Zur Erzeugung der zum Herabmischen der Hochfrequenzsignale benötigten Schwingungen dient in der Anordnung nach Fig. 1 ein gemeinsamer Schwingungsgenerator, der eine allen Signalverarbeitungszweigen gemeinsame phasenverriegelte Schleife 16 und zu jedem der Signalverarbeitungszweige eine gesonderte Oszillatorstufe 17, 18 bzw. 19 umfaßt. Die phasenverriegelte Schleife 16 und die Oszillatorstufen 17, 18 bzw. 19 sind in an sich bekannter Weise miteinander verbunden. Um gegenseitige Störungen der Signalverarbeitungszweige auszuschließen, können die Oszillatorstufen 17, 18, 19 wahlweise über eine Datenleitung 20 ein- bzw. ausgeschaltet werden, so daß nur jeweils die Oszillatorstufe 17, 18 bzw. 19 eine Schwingung abgibt, deren Signalverarbeitungszweig über die Umschaltstufe 3 mit dem Eingang 2 (über den Eingangsverstärker 1) verbunden ist. Die Datenleitung 20 kann dann in gleicher Weise auch an die Umschaltstufe 3 geführt sein. Außerdem ist über einen Dateneingang 21 der phasenverriegelten Schleife 16 die Frequenz der vom Schwingungsgenerator 16 bis 19 abgegebenen Schwingung einstellbar. Der Schwingungsgenerator 16 bis 19 ist ferner mit einem Kristalloszillator 22 als Frequenzreferenz verbunden.

Die steuerbaren Verstärkerstufen 7, 8, 9 weisen einen Steuereingang 23 auf, über den der Verstärkungsfaktor der Verstärkerstufen 7, 8, 9 einstellbar ist. Die steuerbaren Verstärkerstufen 7, 8, 9 können dann in eine Regelschleife zur Amplitudenregelung bzw. Leistungsregelung der Hochfrequenzsignale eingebunden werden.

Die Datenleitung 20 sowie der Dateneingang 21 der phasenverriegelten Schleife 16 können mit einer nicht dargestellten Steuerung für den Empfangsbetrieb der Hochfrequenz-Empfangsstufe verbunden sein.

Die Filterstufen 4, 5, 6 sind über eine Leitung 24 der phasenverriegelten Schleife 16 verbunden. Über diese Leitung 24 können in an sich üblicher Weise Signale für die Frequenzselektion vom Schwingungsgenerator 16 bis 19 zugeführt werden. Insbesondere erhalten in den Filterstufen 4, 5, 6 vorhandene Abstimmdioden die gleiche Abstimmung wie die Oszillatorstufen 17, 18, 19.

Fig. 1 zeigt weiterhin die Einbindung der im vorstehenden beschriebenen Ausführungsform der Hochfrequenz-Empfangsstufe in eine Hochfrequenz-Signalverarbeitung eines Videorecorders. Dazu ist in Fig. 1 eine weitere Eingangsverstärkerstufe 25 dargestellt, die eingangsseitig mit einem Antenneneingang 26 des Videorecorders und ausgangsseitig mit dem Eingang 2 der Hochfrequenz-Empfangsstufe für die Hochfrequenzsignale verbunden ist. Der Eingang 2 ist ferner über einen Durchschleifverstärker 27 mit einem Eingang einer Hochfrequenzsignal-Überlagerungsstufe 28 verbunden. Deren Ausgang bildet einen Antennenausgang 29 des Videorecorders.

Ein Eingang 30 für das Basisband-Videosignal bildet einen ersten Eingang einer Niederfrequenz-Signal-Überlagerungsstufe 31. Ein Eingang 32 für ein Audiosignal ist an eine Audiosignal-Modulationsstufe 33 geführt. Diese ist mit einem zweiten Eingang der Niederfrequenzsignal-Überlagerungsstufe 31 verbunden. In der Audiosignal-Modulationsstufe 33 wird das vom Eingang 32 zugeführte Audiosignal auf eine Hilfsträgerschwingung aufmoduliert und anschließend in der Niederfrequenzsignal-Überlagerungsstufe 31 dem Basisband-Videosignal vom Eingang 30 additiv überlagert. Auf diese Weise wird ein FBAS-Signal erzeugt und über einen Ausgang 34 der Niederfrequenz-Überlagerungsstufe 31 abgegeben. Der Ausgang 34 führt an eine Modulationsstufe 35, in der das FBAS-Signal mit einer Schwingung von einer der Oszillatorstufen, hier der Oszillatorstufe 19 für den dritten Signalverarbeitungszweig, aufwärts gemischt wird. Dabei entsteht ein Hochfrequenzsignal, welches der Hochfrequenzsignal-Überlagerungsstufe 28 zur Weiterleitung an den Antennnenausgang 29 des Videorecorders zugeführt wird.

In Fig. 1 sind die durch die gestrichelte Linie 36 umrandeten Elemente vorteilhaft zu einer integrierten Baugruppe zusammengefaßt. Entsprechend können die durch die strichpunktierte Linie 37 umrandeten Elemente zu einer weiteren integrierten Baugruppe zusammengefaßt sein. Diese integrierten Baugruppen können insbesondere auf einem Halbleiterkörper integriert werden.

Fig. 2 zeigt ein zweites Ausführungsbeispiel der erfindungsgemäßen Hochfrequenz-Empfangsstufe. Darin wurde gegenüber dem Ausführungsbeispiel nach Fig. 1 der breitbandige Eingangsverstärker 1 durch einen breitbandigen steuerbaren Eingangsverstärker 38 ersetzt, der nun zum Zweck einer Amplituden- bzw. Leistungsregelung der Hochfrequenzsignale mit dem Steuereingang 23 verbunden ist. Dagegen entfallen die steuerbaren Verstärkerstufen 7, 8, 9 in den Signalverarbeitungszweigen; sie können in einer Abwandlung der Fig. 2 gegebenenfalls durch Verstärkerstufen mit konstanten Verstärkungsfaktoren ersetzt werden, sofern an diesen Stellen der Schaltungsanordnung eine weitere Signalverstärkung oder Rückflußdämpfung erwünscht ist.

Im übrigen stimmen die Ausführungsbeispiele nach den Figuren 1 und 2 überein.

Eine bevorzugte Anwendung dieser Hochfrequenz-Empfangsstufen liegt bei Hochfrequenz-Verarbeitungsstufen von Satelliten-Empfangsanlagen und Videorecordern.

## Patentansprüche

1. Hochfrequenz-Empfangsstufe mit wenigstens einem Signalverarbeitungszweig zum frequenzselektiven Empfangen, Verstärken und Frequenzmischen von Hochfrequenzsignalen mit einem breitbandigen Eingangsverstärker (1), einer Umschaltstufe (3), über die die von einem Eingang (2) über den Eingangsverstärker zuführbaren Hochfrequenzsignale wahlweise auf einen der Signalverarbeitungszweige geleitet werden können, sowie in jedem Signalverarbeitungszweig weiterhin je einer an die Umschaltstufe angeschlossenen Filterstufe (4, 5 bzw. 6), einer der Filterstufe (4, 5 bzw. 6) nachgeschalteten Verstärkerstufe und einer an die Verstärkerstufe sich anschließenden Mischstufe (10, 11 bzw. 12), wobei die Mischstufen (10, 11 bzw. 12) mit ihren Ausgängen über eine Signalzusammenführung (13) an einen gemeinsamen Ausgangszweig (14, 15) angeschlossen sind,
**dadurch gekennzeichnet, daß** die Eingangssignale (26) der Empfangsstufe ungefiltert dem Eingangsverstärker (1) zugeführt werden, und daß die in jedem der Signalverarbeitungszweige der Filterstufe (4, 5 bzw. 6) nachgeschaltete Verstärkerstufe (7, 8 bzw. 9) mit einem steuerbaren Verstärkungsfaktor ausgebildet ist.

2. Hochfrequenz-Empfangsstufe mit wenigstens einem Signalverarbeitungszweig zum frequenzselektiven Empfangen, Verstärken und Frequenzmischen von Hochfrequenzsignalen mit einem breitbandigen Eingangsverstärker (38), einer Umschaltstufe (3), über die die von einem Eingang (2) zuführbaren Hochfrequenzsignale wahlweise auf einen der Signalverarbeitungszweige geleitet werden können, sowie in jedem Signalverarbeitungszweig weiterhin je einer an die Umschaltstufe (3) angeschlossenen Filterstufe (4, 5 bzw. 6) und einer an die Filterstufe (4, 5 bzw. 6) sich anschließenden Mischstufe (10, 11 bzw. 12), wobei die Mischstufen (10, 11 bzw. 12) mit ihren Ausgängen über eine Signalzusammenführung (13) an einen gemeinsamen Ausgangszweig (14, 15) angeschlossen sind,
wobei die Filterstufe (4, 5 bzw. 6) in jedem Signalverarbeitungszweig unmittelbar mit der Mischstufe (10, 11 bzw. 12) verbunden ist, **dadurch gekennzeichnet, daß** die Einganssignale (26) der Empfangsstufe ungefiltert dem Eingangsverstärker (38) zugefährt werden, und daß der Eingangsverstärker (38) mit einem steuerbaren Verstärkungsfaktor ausgebildet ist.

3. Hochfrequenz-Empfangsstufe nach Anspruch 1 oder 2,
**dadurch gekennzeichnet, daß** die Mischstufen (10, 11 bzw. 12) aller Signalverarbeitungszweige mit einem gemeinsamen Schwingungsgenerator (16, 17, 18, 19) verbunden sind.

4. Hochfrequenz-Empfangsstufe nach Anspruch 3,
**dadurch gekennzeichnet, daß** der Schwingungsgenerator (16, 17, 18, 19) eine gemeinsame phasenverriegelte Schleife (16) und zu jedem der Signalverarbeitungszweige eine gesonderte Oszillatorstufe (17, 18 bzw. 19) umfaßt.

5. Hochfrequenz-Empfangsstufe nach Anspruch 4 in Verbindung mit Anspruch 1,
**dadurch gekennzeichnet, daß** die steuerbaren Verstärkerstufen (7, 8 bzw. 9) und die Mischstufen (10, 11 bzw. 12) aller Signalverarbeitungszweige zusammen mit dem Schwingungsgenerator (16, 17, 18, 19) in einem integrierten Bauteil zusammengefaßt sind.

6. Hochfrequenz-Empfangsstufe nach Anspruch 4 oder 5,
**dadurch gekennzeichnet, daß** der Eingangsverstärker (1) und die Umschaltstufe (3) in einem integrierten Bauteil zusammengefaßt sind.

7. Hochfrequenz-Empfangsstufe nach Anspruch 4 in Verbindung mit Anspruch 2,
**dadurch gekennzeichnet, daß** die Mischstufen (10, 11 bzw. 12) aller Signalverarbeitungszweige zusammen mit dem Schwingungsgenerator (16, 17, 18, 19) in einem integrierten Bauteil zusammengefaßt sind.

## Claims

1. A tuner having at least one signal-processing branch for frequency-selective reception, amplification and/or frequency conversion of RF signals by means of a wideband input amplifier (1), a switching stage (3) via which the RF signals, which can be supplied from an input (2) via the input amplifier, can optionally be passed through one of the signal-processing branches, each signal-processing branch further comprising a filter stage (4, 5, 6) connected to the switching stage, a controllable amplifier stage arranged subsequent to the filter stage (4, 5, 6), and a mixer stage (10, 11, 12) succeeding the amplifier stage, the outputs of said mixer stages (10, 11, 12) being connected to a common output branch (14, 15) via a signal junction (13), **characterized in that** the input signals (26) of the tuner are applied in an unfiltered form to the input amplifier (1), and **in that** the amplifier stage (7, 8, 9) arranged subsequent to each signal-processing branch of the filter stages (4, 5, 6) has a controllable gain factor.

2. A tuner having at least one signal-processing branch for frequency-selective reception, amplification and/or frequency conversion of RF signals by means of a wideband input amplifier (38), a switching stage (3) via which the RF signals, which can be supplied from an input (2), can optionally be passed through one of the signal-processing branches, each signal-processing branch further comprising a filter stage (4, 5, 6) connected to the switching stage (3) and a mixer stage (10, 11, 12) succeeding the filter stage (4, 5, 6), the outputs of said mixer stages (10, 11, 12) being connected to a common output branch (14, 15) via a signal junction (13), the filter stage (4, 5, 6) in each signal-processing branch being directly connected to the mixer stage (10, 11, 12), **characterized in that** the input signals (26) of the tuner are applied in an unfiltered form to the input amplifier (38), and **in that** the input amplifier (38) has a controllable gain factor.

3. A tuner as claimed in claim 1 or 2, **characterized in that** the mixer stages (10, 11, 12) of all signal-processing branches are connected to a common oscillation generator (16, 17, 18, 19).

4. A tuner as claimed in claim 3, **characterized in that** the oscillation generator (16, 17, 18, 19) comprises a common phase-locked loop (16) and a separate oscillator stage (17, 18, 19) for each signal-processing branch.

5. A tuner as claimed in claim 4, where appendant to claim 1, **characterized in that**, together with the oscillation generator (16, 17, 18, 19), the controllable amplifier stages (7, 8, 9) and the mixer stages (10, 11, 12) of all signal-processing branches are combined in an integrated component.

6. A tuner as claimed in claim 4 or 5, **characterized in that** the input amplifier (1) and the switching stage (3) are combined in an integrated component.

7. A tuner as claimed in claim 4, where appendant to claim 2, **characterized in that**, together with the oscillation generator (16, 17, 18, 19), the mixer stages (10, 11, 12) of all signal-processing branches are combined in an integrated component.

## Revendications

1. Etage récepteur à haute fréquence avec au moins une branche de traitement de signaux pour la réception, l'amplification et le mélange de fréquences à sélection de fréquence de signaux à haute fréquence avec un amplificateur d'entrée (1) à large bande, un étage de commutation (3) par l'intermédiaire duquel les signaux à haute fréquence à amener par une entrée (2) par l'intermédiaire de l'amplificateur d'entrée peuvent au choix être amenés sur une des branches de traitement de signaux ainsi que respectivement, dans chaque branche de traitement de signaux, un étage de filtrage (4, 5 ou 6) raccordé à l'étage de commutation, un étage amplificateur monté en aval d'un des étages de filtrage (4, 5 ou 6) et un étage de mélange (10, 11 ou 12) raccordé à l'étage amplificateur, les étages de mélange (10, 11 ou 12) étant raccordés par leurs sorties par l'intermédiaire d'une combinaison de signaux (13) à une branche de sortie (14, 15) commune, **caractérisé en ce que** les signaux d'entrée (26) de l'étage récepteur sont amenés non filtrés à l'amplificateur d'entrée (1) et que l'étage amplificateur monté en aval de l'étage de filtrage (4, 5 ou 6) dans chacune des branches de traitement de signaux est conçu avec un facteur d'amplification commandable.

2. Etage récepteur à haute fréquence avec au moins une branche de traitement de signaux pour la réception, l'amplification et le mélange de fréquences à sélection de fréquence de signaux à haute fréquence avec un amplificateur d'entrée (38) à large bande, un étage de commutation (3) par l'intermédiaire duquel les signaux à haute fréquence à amener par une entrée (2) peuvent au choix être dirigés sur l'une des branches de traitement de signaux ainsi que respectivement, dans chaque branche de traitement de signaux, un étage de filtrage (4, 5 ou 6) raccordé à l'étage de commutation (3) et un étage de mélange (10, 11 ou 12) adjacents à l'étage de filtrage (4, 5 ou 6), les étages de mélange (10, 11 ou 12) étant raccordés par leurs sorties par l'intermédiaire d'une combinaison de signaux (13) à une branche de sortie (14, 15) commune, l'étage de filtrage (4, 5 ou 6) dans chaque branche de traitement de signaux étant relié directement avec l'étage de mélange (10, 11 ou 12) **caractérisé en ce que** les signaux d'entrée (26) de l'étage récepteur sont amenés non filtrés à l'amplificateur d'entrée (38) et que l'amplificateur d'entrée (38) est conçu avec un facteur d'amplification commandable.

3. Etage récepteur à haute fréquence selon l'une des revendications 1 ou 2, **caractérisé en ce que** les étages de mélange (10, 11 ou 12) de toutes les branches de traitement de signaux sont reliés à un générateur d'oscillations commun (16, 17, 18, 19).

4. Etage récepteur à haute fréquence selon la revendication 3, **caractérisé en ce que** le générateur d'oscillations (16, 17, 18, 19) comprend une boucle à verrouillage de phase commune (16) et à chacun des branches de traitement de signaux un étage d'oscillateur (17, 18 ou 19) distinct.

5. Etage récepteur à haute fréquence selon la revendication 4 associée à la revendication 1, **caractérisé en ce que** les étages amplificateurs (7, 8 ou 9) commandables et les étages de mélange (10, 11 ou 12) de toutes les branches de traitement de signaux sont combinés avec le générateur d'oscillations (16, 17, 18, 19) en un module intégré.

6. Etage récepteur à haute fréquence selon l'une des revendications 4 ou 5, **caractérisé en ce que** l'amplificateur d'entrée (1) et l'étage de commutation (3) sont combinés en un module intégré.

7. Etage récepteur à haute fréquence selon la revendication 4 associée à la revendication 2, **caractérisé en ce que** les étages de mélange (10, 11 ou 12) de toutes les branches de traitement de signaux sont combinés avec le générateur d'oscillations (16, 17, 18, 19) en un module intégré.
